# EUROPEAN PATENT SPECIFICATION

(11) **EP 3 564 992 B1**
(45) Date of publication and mention of the grant of the patent: **07.07.2021**
(21) Application number: 18170404.0
(22) Date of filing: 02.05.2018
(51) Int. Cl.: H01L 23/367, H01L 23/467, F28F 3/12, F28F 3/06, F28F 3/02, H05K 7/20

(54) **FLUID-BASED COOLING DEVICE FOR COOLING AT LEAST TWO DISTINCT FIRST HEAT-GENERATING ELEMENTS OF A HEAT SOURCE ASSEMBLY**
FLUIDBASIERTE KÜHLVORRICHTUNG ZUM KÜHLEN VON MINDESTENS ZWEI VERSCHIEDENEN ERSTEN WÄRMEERZEUGENDEN ELEMENTEN EINER WÄRMEQUELLENANORDNUNG
DISPOSITIF DE REFROIDISSEMENT À BASE DE FLUIDE POUR REFROIDIR AU MOINS DEUX PREMIERS ÉLÉMENTS GÉNÉRATEURS DE CHALEUR DISTINCTS D'UN ENSEMBLE DE SOURCE DE CHALEUR

(43) Date of publication of application: 06.11.2019
(73) Proprietor: EKWB d.o.o., 1218 Komenda (SI)
(72) Inventor: KÖNIG, Edvard, 1000 Ljubljana (SI); HARPER, Daniel George, Charlton London, SE7 /PB (SI)
(74) Representative: Schaumburg und Partner Patentanwälte mbB

(56) References cited:
- US-A- 5 973 921
- US-A- 6 062 301
- US-A1- 2017 055 378

## Description

The invention relates to a fluid-based cooling device for cooling at least two distinct first heat-generating elements of a heat source assembly. The heat source assembly is in thermal contact with the fluid-based cooling device. The fluid-based cooling device comprises a first plate, a heat sink structure and a second plate. The first plate is configured for thermally contacting the heat source assembly. The heat sink structure is arranged on the first plate. The second plate is configured for directing a flow of a cooling fluid to the heat sink structure. The second plate is arranged on the heat sink structure.

A state-of-the-art fluid heat exchanger for cooling an electronic device comprises a first plate in thermal contact with a heat generating element, a second plate having a fluid inlet opening and a heat sink structure comprising a plurality of fins arranged between the first and second plates. Typically, the fluid inlet opening of the second plate is arranged centered (or a little off-center) atop the heat sink structure to disperse a cooling fluid over the heat sink structure. The heat sink structure comprises an arrangement of parallel fins machined into the first plate. The parallel fins are arranged to form micro-channels between them allowing the cooling fluid to flow between them such that heat can be transferred from the first plate to the cooling fluid. Such a fluid-based cooling device is disclosed in US 8,746,330 B2 and US 2017/0196116 A1.

US 2008/0264604 A1 discloses a cooling apparatus for removing heat from an electronic device. The cooling apparatus comprises a manifold structure having a plurality of coolant inlet and outlet passageways interleaved in the manifold structure. The manifold structure further includes coolant inlet and outlet plenums, with cooling fluid passing through the inlet passageways from the inlet plenum in a first direction and cooling fluid passing through the outlet passageways to the outlet plenum in a second direction. The first and second directions are perpendicular to a surface to be cooled.

WO 2004/042302 A2 discloses a fluid cooled channeled heat exchanger device comprising two flat coupled plates and a plurality of fins coupled to the two plates. One of the plates comprises a plurality of condenser channels configured to receive, to condense and to cool a cooling fluid in a heated state.

GB 2 402 465 A discloses a split flow heat exchanger comprising a cylindrical chamber having an inlet communicating a heating fluid to a header and a heat transfer device comprising an enclosure with a plurality of tubes.

US 2017/0055378 A1 discloses a modular jet impingement assembly according to the preamble of claim 1 that allows the modular setup of a cooling device. Cooling fluid flows through modular manifolds of the assembly to provide cooling to heat generating elements. Each heat generating element is thermally coupled to a single dedicated modular manifold by means of a dedicated heat transfer plate. Each heat transfer plate comprising a heat sink structure on an impingement surface of the heat transfer plate.

Known fluid-based cooling devices fail to optimally cool a heat source assembly, e.g. a CPU or GPU assembly, comprising more than one distinct heat-generating elements, e.g. two or more CPU or GPU dies, when the distinct heat-generating elements are spatially separated from each other.

It is an object of the present invention to provide a fluid-based cooling device for cooling at least two distinct first heat-generating elements of a heat source assembly allowing for an optimal cooling of at least two spatially separated first heat-generating elements.

This object is solved by a fluid-based cooling device having the features of claim 1. Advantageous developments of the invention are specified in the dependent claims.

According to an embodiment, a fluid-based cooling device for cooling at least two distinct first heat-generating elements of a heat source assembly is provided. The heat source assembly is in thermal contact with the fluid-based cooling device. The fluid-based cooling device comprises a first plate, a heat sink structure and a second plate.

The first plate is configured for thermally contacting the heat source assembly. The heat sink structure is arranged on or in the first plate. The second plate is configured for directing a flow of a cooling fluid to the heat sink structure. The second plate is arranged on the heat sink structure. The heat sink structure comprises at least two heat sink structure portions each corresponding to an associated one of the at least two distinct first heat-generating elements. The second plate comprises at least two fluid inlet opening regions, wherein each of the fluid inlet opening regions is associated with a corresponding heat sink structure portion of the at least two heat sink structure portions.

Areas of the heat source assembly where the at least two first heat-generating elements are arranged constitute areas of high heat flux, i.e. they heat up more quickly than the remaining areas of the heat source assembly. Since the heat source assembly is in thermal contact with the first plate, the first plate will heat up more quickly in areas associated with the at least two first heat-generating elements. Each of the at least two heat sink structure portions is associated with at least one of the at least two distinct first heat-generating elements, e.g. arranged on the first plate atop the at least one heat-generating element. For optimally cooling the first plate and thereby cooling the heat source assembly, a cooling fluid (coolant) is dispersed over the heat sink structure through the at least two fluid inlet opening regions. Each of the at least two fluid inlet opening regions is associated with a corresponding one of the at least two heat sink structure portions, so that the cooling fluid can selectively be provided for each of the at least two heat sink structure portions. Heat is transferred from each of the at least two heat sink structure portions to the cooling fluid heating the same up, thereby allowing to divert the heat away specifically from the areas of the heat source assembly where the at least two first heat-generating elements are arranged.

The present invention thus allows for an optimal cooling of at least two spatially separated first heat-generating elements of a heat source assembly such as a multi-die CPU or GPU. By means of the fluid-based cooling device of the present invention, it is possible to optimize the flow of the cooling fluid through the fluid-based cooling device, thereby achieving an optimal cooling performance.

Preferably, the heat sink structure comprises a plurality of fins extending in parallel in a first direction. The fluid inlet opening regions longitudinally extend in a second direction perpendicular to the first direction. This allows for the cooling fluid to be evenly dispersed among the heat sink structure allowing for a uniform cooling of the first plate and thereby the heat source assembly.

Preferably, the fluid-based cooling device (including the first plate) has a rectangular shape having a long side and a short side. For example, the long side of the fluid-based cooling device (or the first plate) is parallel to the first direction (i.e. parallel to the fins), while the short side of the fluid-based cooling device (or the first plate) is parallel to the second direction (i.e. perpendicular to the fins). In this case, the long side of the heat source assembly having a rectangular shape is parallel to the first direction, while the short side of the heat source assembly having the rectangular shape is parallel to the second direction. Further, the short side of the fluid-based cooling device (or the first plate) may be parallel to the first direction (i.e. parallel to the fins), while the long side of the fluid-based cooling device (or the first plate) may be parallel to the second direction (i.e. perpendicular to the fins). In this case, the short side of the heat source assembly having a rectangular shape may be parallel to the first direction, while the long side of the heat source assembly having the rectangular shape may be parallel to the second direction.

If the heat sink structure is, for example, a high-density structure not comprising fins, the first direction may be defined by the short side of the fluid-based cooling device (or the first plate) instead of the (longitudinal) extension of the fins, while the second direction may be defined by the long side of the fluid-based cooling device (or the first plate). Further, in this case, the first direction may also be defined by the long side of the fluid-based cooling device (or the first plate) instead of the (longitudinal) extension of the fins, while the second direction may also be defined by the short side of the fluid-based cooling device (or the first plate). In other words, the configuration of the fluid-based cooling device including the fluid inlet opening regions can be defined with respect to the short or long side of the fluid-based cooling device, i.e. the configuration can be rotated by 90°.

Preferably, the fluid inlet opening regions have at least a first width adapted to one or more of the at least two first heat-generating elements. This allows for the cooling fluid to be spread in different amounts over the at least two heat sink structure portions allowing different amounts of cooling fluid for different parts of the heat sink structure and thereby the first plate and the heat source assembly.

Preferably, the fluid inlet opening regions have a second width provided for one or more of second heat-generating elements or non-heat-generating elements of the heat source assembly.

Preferably, the first width is larger than the second width.

The non-heat-generating elements, e.g. structural elements of the heat source assembly, do not generate heat themselves. However, due to the presence of the first heat-generating elements, the non-heat-generating elements may heat up during use and also need cooling. For example, the second heat-generating elements are CPU dies which are not disabled, but are intentionally designed in such a way that they generate less heat than the main CPU dies.

The provision of the fluid inlet opening regions with the relatively small second width allows for the cooling fluid to be spread in relatively small amounts to parts of the heat sink structure (i.e. those corresponding to the second heat-generating elements or non-heat-generating elements) which during use would not heat up as much as other parts of the heat sink structure (i.e. those corresponding to the first heat-generating elements).

For example, a first fluid inlet opening region of the fluid inlet opening regions having the first width and a second fluid inlet opening region of the fluid inlet opening regions having the second width are spatially separated or connected with each other.

It is advantageous when the fluid-based cooling device is configured for cooling four distinct first heat-generating elements of the heat source assembly and when the second plate comprises four fluid inlet opening regions corresponding to the four distinct first heat-generating elements.

Preferably, the fluid-based cooling device is configured for cooling a first pair of diagonally arranged first heat-generating elements and a second pair of diagonally arranged second heat-generating elements or non-heat-generating elements. The second plate comprises four fluid inlet opening regions. Two of the four fluid inlet opening regions corresponding to the first heat-generating elements of the first pair have a width which is larger than the width of the other two of the four fluid inlet opening regions corresponding to the second heat-generating elements or non-heat-generating elements of the second pair. Thus, a larger amount of cooling fluid can be provided through the two of the four fluid inlet opening regions corresponding to the first heat-generating elements than through the other two of the four fluid inlet opening regions corresponding to the second heat-generating elements or non-heat-generating elements. Accordingly, the cooling of the heat source assembly can further be optimized.

It is advantageous when the heat sink structure comprises at least two spatially separated heat sink structure portions forming at least a first intermediate channel and/or a second intermediate channel for diverting the cooling fluid after having been heated therefrom.

For example, the heat sink structure comprises a plurality of fins extending in parallel in a first direction, and the first intermediate channel extends in a second direction perpendicular to the first direction.

For example, the heat sink structure comprises a plurality of fins extending in parallel in a first direction, and the second intermediate channel extends in the first direction.

Alternatively, a first and a second of the at least two heat sink structure portions are connected with each other without forming an intermediate channel therebetween.

Preferably, the fluid-based cooling device comprises a third plate arranged above the first and the second plate. The first, the second and/or the third plate comprises at least one cooling fluid input or output channel. The third plate is utilized to provide a fluid chamber for the cooling fluid to be directed via the cooling fluid input or output channel to the heat sink structure and further optimize the flow of the cooling fluid through the fluid-based cooling device. Thereby, further optimizing the cooling of the heat source assembly can be achieved.

It is advantageous when the first plate comprises at least two contact surfaces protruding from a surface of the first plate facing away from the heat sink structure for thermally contacting a heat spreader of the heat source assembly and when the contact surfaces each correspond to the at least two distinct first heat-generating elements.

Preferably, the contact surfaces of the first plate are spatially separated, thereby forming at least one intermediate channel for receiving a thermal interface material (TIM).

Thermal interface material, e.g. thermal grease, is used to increase the thermal contact between the fluid-based cooling device and the heat source assembly. However, if the contact surfaces between the fluid-based cooling device and the heat source assembly are too large, it becomes difficult to evenly spread the thermal interface material evenly over the contact surfaces. Thus, the intermediate channel provides a space for excess thermal interface material to spread to.

For example, the heat sink structure comprises a plurality of fins and/or pins and/or micro-channels (cavities) defined by the fins. The heat sink structure may be any high-density structure, i.e. structure having a plurality of protrusions characterized by a large (maximized) surface area. Further, the protrusions (e.g. fins) may have different shapes such as longitudinally extending parallel or angled fins.

In particular, the heat sink structure may comprise a fin or pin structure or other high density cooling structure, e.g. structure comprising fins and pins, having different pin forms, such as elliptic, dropform, NACA, circular or square.

The heat source assembly may be a CPU or GPU assembly. The first heat-generating elements and/or the second heat-generating elements are, for example, CPU or GPU dies containing multiple CPU or GPU, respectively, or single, preferably high performance CPU or GPU. The non-heat-generating elements may be non-functional or disabled semiconductor dies or structural elements, e.g. supporting the heat spreader. Preferably, the second heat-generating elements are configured to generate less heat than the first heat-generating elements.

Preferably, the first plate and/or the heat sink structure are made from a material with a high thermal conductivity, e.g. copper, aluminum or an alloy thereof.

For example, the first, second and/or third plate are manufactured by means of injection molding or milling. Preferably, the first, second and/or third plate are substantially plate-shaped elements. The second plate is a fluid directing element and can also be referred to as "impingement plate". The second plate may also be of a shape other than plate-shaped.

Alternatively, the first and/or second intermediate channel may be formed in the second or second and third plate. In this case, the two heat sink structure portions of the heat sink structure may be connected with each other without forming an intermediate channel therebetween. By means of the first and/or second intermediate channel formed in the second or second and third plate, the cooling fluid after having been heated when flowing through the heat sink structure can be diverted therefrom. In other words, the heated cooling fluid can also exit the fluid-based cooling device via the intermediate channels formed in the second or second and third plate above the (continuous) heat sink structure.

In the case that the first and/or second intermediate channel are formed in the second or second and third plate, the two fluid inlet opening regions of the second plate may be connected with each other. For example, the fluid inlet opening regions may be of a straight or curved shape and together may form the shape of an "X" (e.g. X-shape or similar shape).

Preferably, in a cross section view, the fluid-based cooling device comprises the two fluid inlet opening regions of the second plate and one intermediate channel (e.g. one of the first and/or second intermediate channel formed in the second or second and third plate or one of the first and/or second intermediate channel formed by the two spatially separated heat sink structure portions) arranged preferably centrally between the two fluid inlet opening regions.

Preferably, the heat sink structure and the first plate are integrally formed, i.e. the heat sink structure may be part of the first plate, or the heat sink structure and the first plate may be two separate elements of the fluid-based cooling device. For example, the heat sink structure may be arranged in the first plate (e.g. on a recessed inner surface of the first plate), or the heat sink structure may be arranged on the first plate (e.g. on an upper surface of the first plate).

Further features and advantages of the invention result from the following description which explains the invention in more detail on the basis of embodiments in connection with the enclosed schematic figures:
- Figure 1: shows a top perspective view of a fluid-based cooling device according to a first embodiment with a first plate and a second plate, the second plate having two lengthwise continuous fluid inlet opening regions;
- Figure 2: shows a perspective cross section view of the fluid-based cooling device according to the first embodiment;
- Figure 3: shows a top view of the fluid-based cooling device according to the first embodiment;
- Figure 4: shows a top perspective view of the fluid-based cooling device according to a second embodiment with the second plate having two lengthwise continuous fluid inlet opening regions of varying width;
- Figure 5: shows a perspective cross section view of the fluid-based cooling device according to the second embodiment;
- Figure 6: shows a top view of the fluid-based cooling device according to the second embodiment;
- Figure 7: shows a top perspective view of the fluid-based cooling device according to a third embodiment with the second plate having four lengthwise spatially separated fluid inlet opening regions;
- Figure 8: shows a top view of the fluid-based cooling device according to the third embodiment;
- Figure 9: shows a top perspective view of the fluid-based cooling device according to a fourth embodiment with the second plate having four lengthwise spatially separated fluid inlet opening regions with two of the four fluid inlet opening regions having a different width than the remaining two fluid inlet opening regions;
- Figure 10: shows a top view of the fluid-based cooling device according to the fourth embodiment;
- Figure 11a: shows a top view of the fluid-based cooling device according to a fifth embodiment with the second plate having two coolant evacuation openings;
- Figure 11b: shows a top view of the fluid-based cooling device according to a sixth embodiment with the second plate having the two coolant evacuation openings;
- Figure 12: shows a bottom view of a third plate of the fluid-based cooling device according to the fifth and sixth embodiment;
- Figure 13: shows a top view of the fluid-based cooling device according to a seventh embodiment with four coolant evacuation openings;
- Figure 14: shows a bottom view of the third plate of the fluid-based cooling device according to a seventh embodiment;
- Figure 15: shows a bottom perspective view of the first plate of the fluid-based cooling device according to the first to seventh embodiment;
- Figure 16: shows a top perspective view of a fluid-based cooling device according to the prior art; and
- Figure 17: shows a bottom perspective view of a first plate of the fluid-based cooling device according to the prior art.

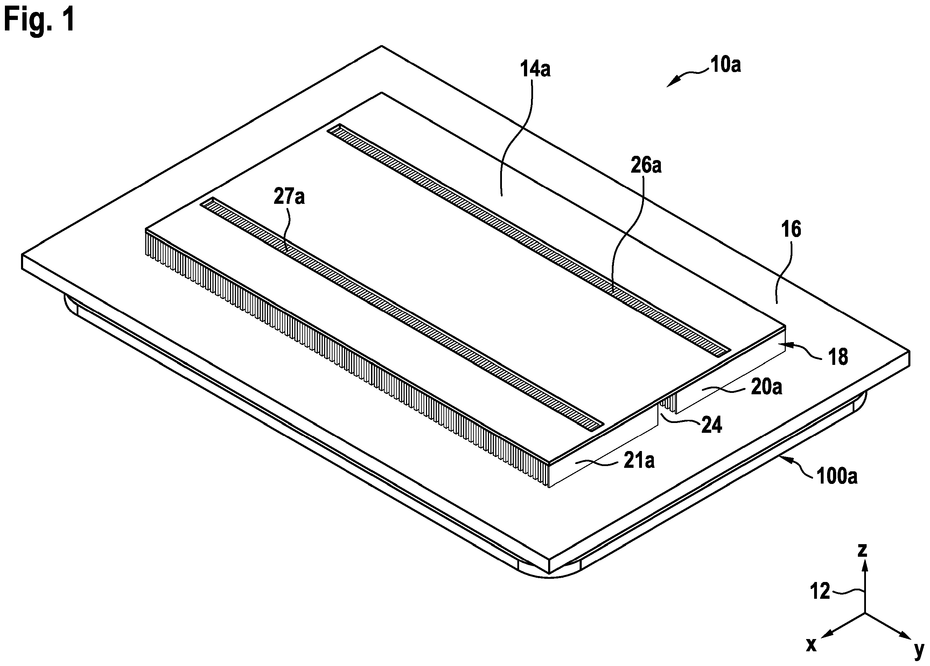

Figures 1 to 3 show a fluid-based cooling device 10a according to a first embodiment with a first plate 16 and a second plate 14a having two lengthwise continuous (and constant-width) fluid inlet opening regions 26a, 27a.

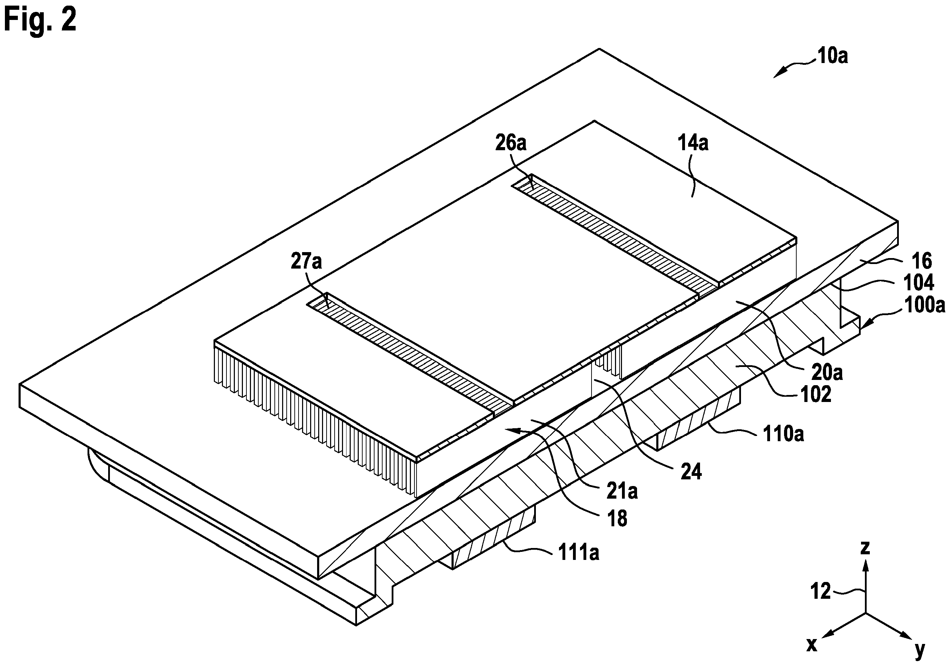

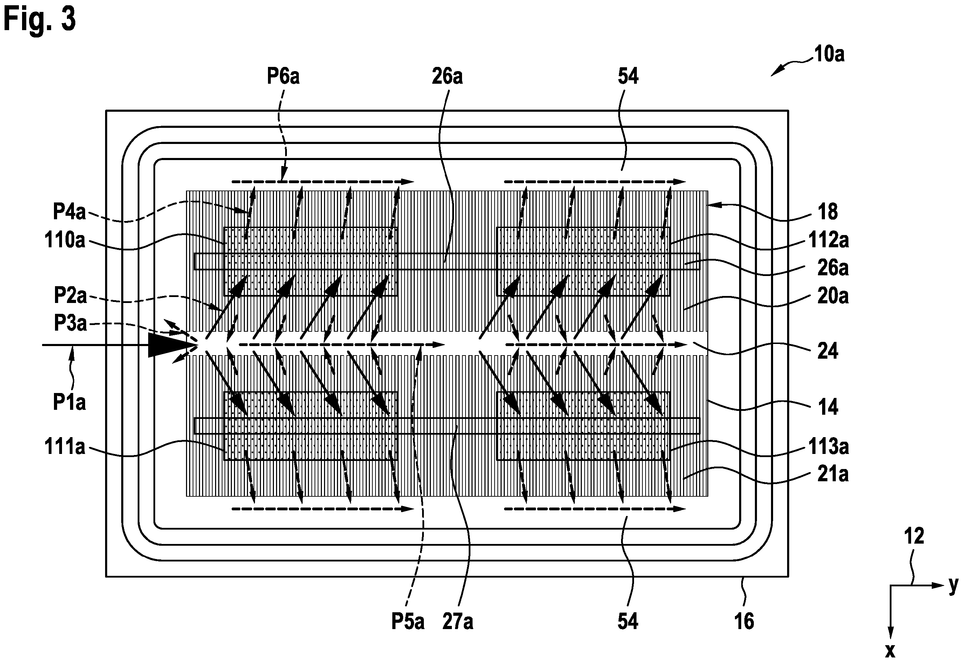

Figure 1 shows a top perspective view of the fluid-based cooling device 10a according to the first embodiment. Figure 1 also shows a coordinate system 12 having an x-axis corresponding to a first direction, a y-axis corresponding to a second direction and a z-axis corresponding to a third direction. The fluid-based cooling device 10a is arranged atop a heat source assembly 100a, e.g. a CPU assembly, which is described in more detail later in conjunction with figures 2 and 3. The fluid-based cooling device 10a further comprises a heat sink structure 18 arranged between the second plate 14a and the first plate 16.

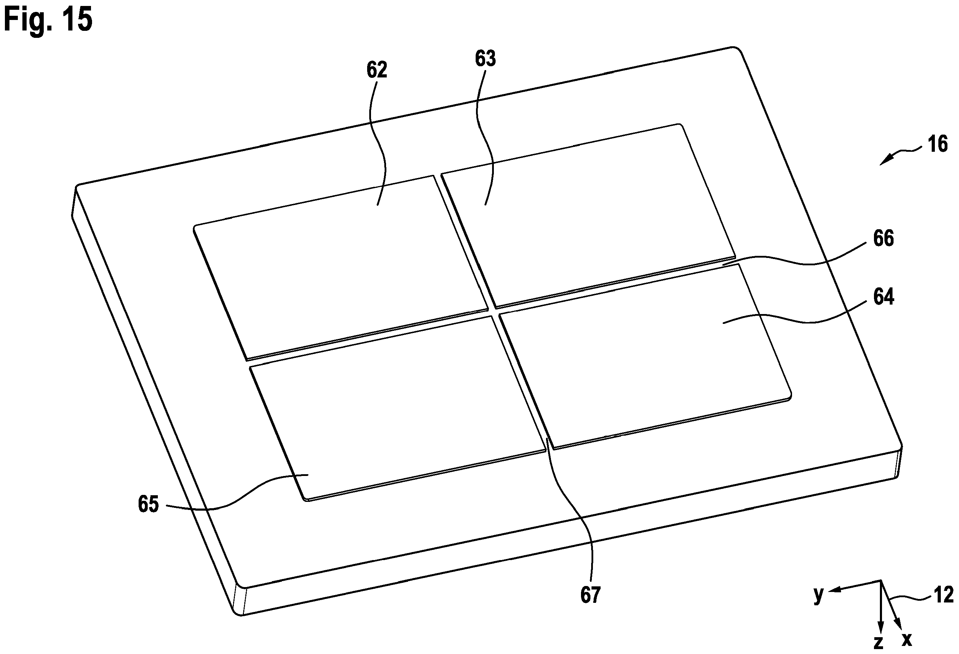

The first plate 16 is made from a material with high thermal conductivity, e.g. an aluminum alloy, and is in thermal contact with the heat source assembly 100a. The first plate 16 conducts heat generated by the heat source assembly 100a to the heat sink structure 18 arranged atop the first plate 16. The first plate 16 is described in more detail later in conjunction with figure 15.

The heat sink structure 18 has a first heat sink structure portion 20a, a second heat sink structure portion 21a and a single intermediate channel 24 which extends along the direction of the y-axis and is arranged between the first and second heat sink structure portions 20a, 21a. The first and second heat sink structure portions 20a, 21a comprise an arrangement of parallel fins extending along the direction of the x-axis each made from a material with a high thermal conductivity, e.g. an aluminum alloy. The parallel fins are arranged to form micro-channels between them allowing a cooling fluid (coolant) to flow between them such that heat can be transferred from the first and second heat sink structure portions 20a, 21a to the cooling fluid.

The second plate 14a has the first fluid inlet opening region 26a and the second fluid inlet opening region 27a formed as elongated openings extending along the y-axis each. The first fluid inlet opening region 26a is arranged centered atop of the first heat sink structure portion 20a. The second fluid inlet opening region 27a is arranged centered atop of the second heat sink structure portion 21a. The first and second fluid inlet opening regions 26a, 27a disperse the cooling fluid flowing into the same from the top of the fluid-based cooling device 10a equally among the micro-channels formed by the parallel fins of the first and second heat sink structure portions 20a, 21a respectively.

Figure 2 shows a perspective cross section view of the fluid-based cooling device 10a according to the first embodiment and the heat source assembly 100a. The fluid-based cooling device 10a and the heat source assembly 100a are cut along a cutting plane extending along the x-axis and z-axis.

According to the first embodiment, the heat source assembly 100a comprises four heat-generating elements 110a to 113a arranged in a grid-like manner, e.g. four CPU dies comprising multiple CPU each arranged on a printed circuit board (PCB), two of which are shown in figure 2, and a heat spreader 102. The heat spreader 102 is arranged between the heat-generating elements 110a to 113a and the first plate 16. The heat spreader 102 is made from a material with high thermal conductivity, e.g. an aluminum alloy, and is in thermal contact with both the four heat-generating elements 110a to 113a and the first plate 16. A layer of thermal interface material 104, e.g. thermal grease, is arranged between the first plate 16 and the heat spreader 102. The layer of thermal interface material (TIM) 104 improves the thermal contact between the first plate 16 and the heat spreader 102.

Figure 3 shows a top view of the fluid-based cooling device 10a according to the first embodiment. The second plate 14a, the first plate 16, the heat sink structure 18 and the heat spreader 102 are shown transparent in Figure 3 to illustrate the spatial arrangement of the components of the fluid-based cooling device 10a in relation to the components of the heat source assembly 100a. Additionally, arrows P1a to P6a are shown to illustrate the flow of the cooling fluid through the fluid-based cooling device 10a.

As can be seen in figure 3, the first heat sink structure portion 20a is arranged atop the first and third heat-generating elements 110a, 112a. The second heat sink structure portion 21a is arranged atop the second and fourth heat-generating elements 111a, 113a.

In operation, cold cooling fluid flows through the fluid-based cooling device 10a in (or against) the direction of the y-axis, i.e. from the left (or right) in figure 3, and indicated by a solid arrow P1a. The cold cooling fluid spreads over the second plate 14a as indicated by solid arrows P2a. After passing through the first and second fluid inlet opening regions 26a, 27a the cold coolant fluid is dispersed equally among the micro-channels formed by the parallel fins of the first and second heat sink structure portions 20a, 21a, respectively. Heat is transferred from the first and second heat sink structure portions 20a, 21a to the cold cooling fluid. A part of the now hot (i.e. heated) cooling fluid exits the first and second heat sink structure portions 20a, 21a, and flows into the single intermediate channel 24 as indicated by short dashed arrows P3a. The remaining part of the now hot (i.e. heated) cooling fluid exits the first and second heat sink structure portions 20a, 21a and flows into a cavity 54, which encompasses the heat sink structure 18 and the second plate 14a, as indicated by short dashed arrows P4a. The hot cooling fluid exits the fluid-based cooling device 10a via the single intermediate channel 24 and the cavity 54 in (or against) the direction of the y-axis, i.e. to the left (or right) in figure 3, as indicated by long dashed arrows P5a, P6a.

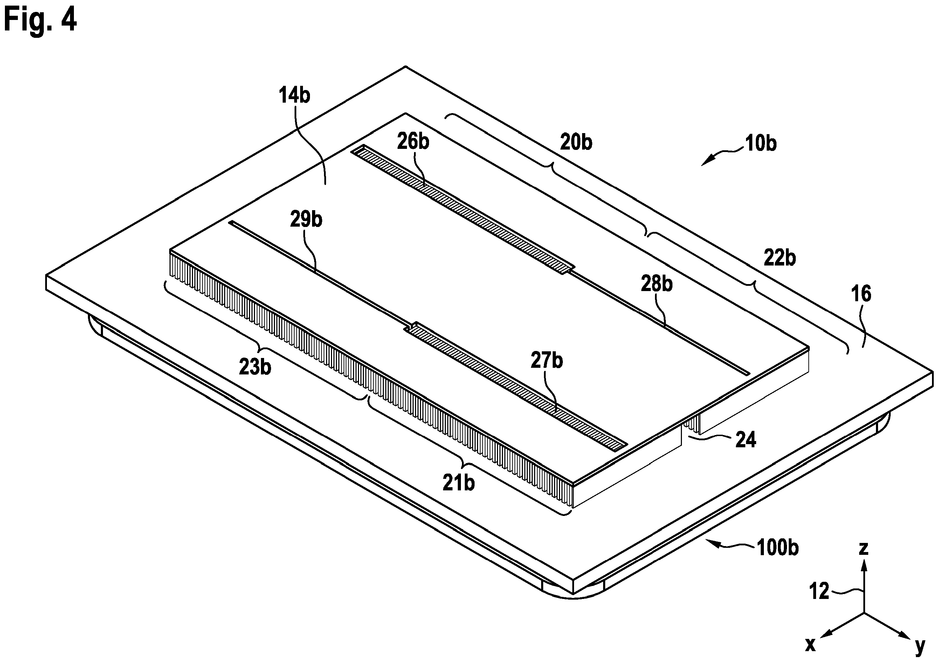

Figures 4 to 6 show a fluid-based cooling device 10b according to a second embodiment with the second plate 14b having two lengthwise continuous fluid inlet opening regions of varying width.

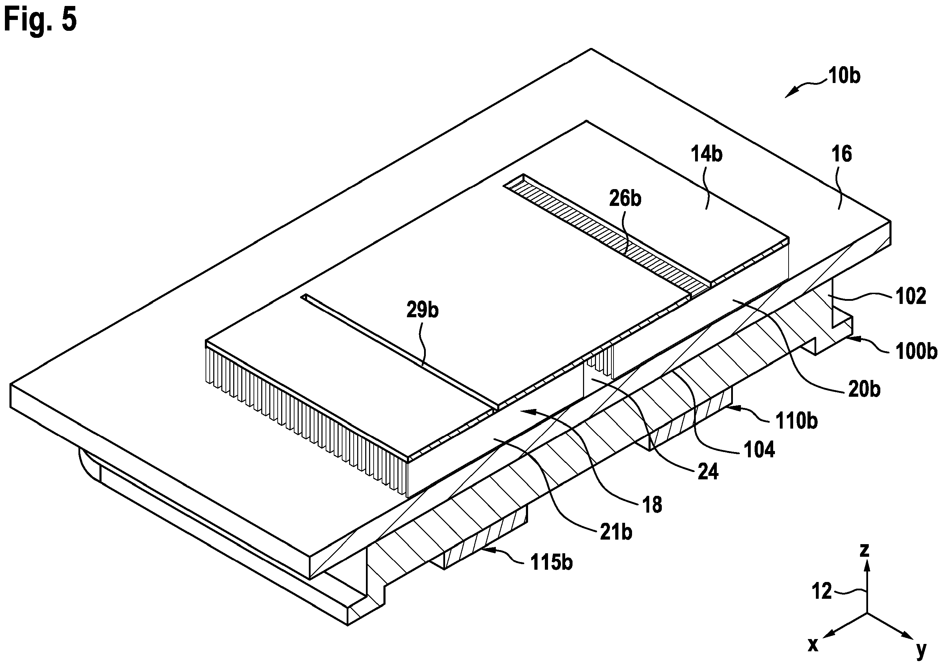

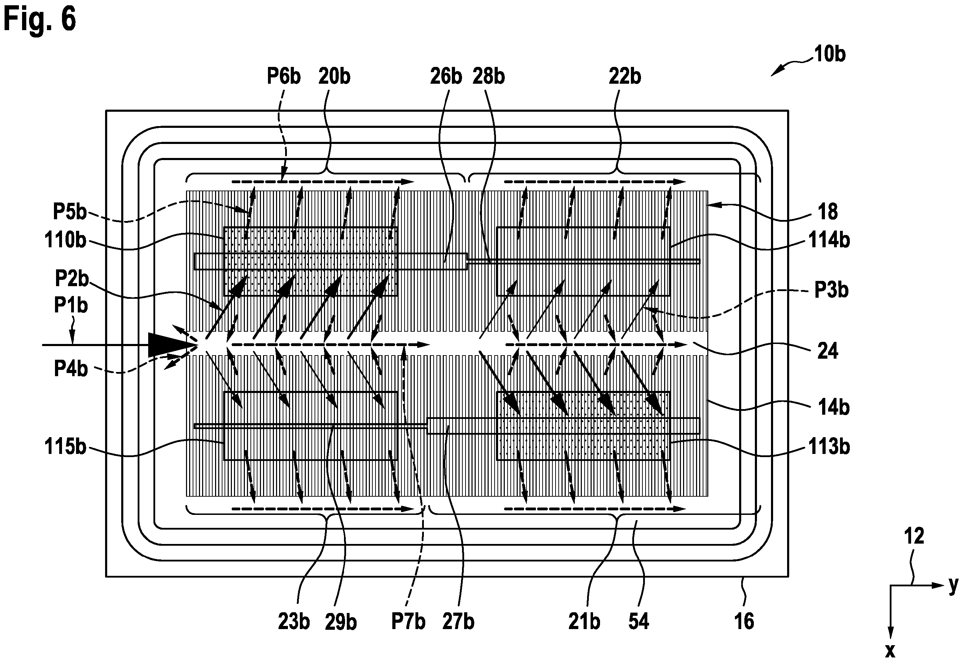

Figure 4 shows a top perspective view of the fluid-based cooling device 10b according to the second embodiment. The fluid-based cooling device 10b is arranged atop a heat source assembly 100b, e.g. a CPU assembly, which is described in more detail later in conjunction with figures 5 and 6.

The fluid-based cooling device 10b according to the second embodiment shown in figures 4 to 6 differs from the fluid-based cooling device 10a according to the first embodiment shown in figures 1 to 3 in having a third (constant-width) fluid inlet opening region 28b and a fourth (constant-width) fluid inlet opening region 29b. Further, the fluid-based cooling device 10b according to the second embodiment shown in figures 4 to 6 further differs from the fluid-based cooling device 10a according to the first embodiment shown in figures 1 to 3 in having a third heat sink structure portion 22b and a fourth heat sink structure portion 23b.

The first (constant-width) fluid inlet opening region 26b and the second (constant-width) fluid inlet opening region 27b have a width greater than the third (constant-width) fluid inlet opening region 28b and the fourth (constant-width) fluid inlet opening region 29b. The first fluid inlet opening region 26b and the third fluid inlet opening region 28b are connected with each other forming a first of the two lengthwise continuous fluid inlet opening regions of varying width. The second fluid inlet opening region 27b and the fourth fluid inlet opening region 29b are connected with each other forming a second of the two lengthwise continuous fluid inlet opening regions of varying width. The first fluid inlet opening region 26b is arranged diagonally opposed to the second fluid inlet opening region 27b. The third fluid inlet opening region 28b is arranged diagonally opposed to the forth fluid inlet opening region 29b.

Figure 5 shows a perspective cross section view of the fluid-based cooling device 10b according to the second embodiment and the heat source assembly 100b. The fluid-based cooling device 10b and the heat source assembly 100b are cut along a cutting plane extending along the x-axis and z-axis.

According to the second embodiment, the heat source assembly 100b comprises two heat-generating elements 110b and 113b, e.g. two CPU dies comprising multiple CPU each, and two non-heat-generating elements 114b and 115b, e.g. two non-functional semiconductor dies used as a purely structural element supporting the heat spreader 102.

Figure 6 shows a top view of the fluid-based cooling device 10b according to the second embodiment. The second plate 14b, the first plate 16, the heat sink structure 18 and the heat spreader 102 are shown transparent in Figure 6 to illustrate the spatial arrangement of the components of the fluid-based cooling device 10b in relation to the components of the heat source assembly 100b. Additionally, arrows P1b to P7b are shown to illustrate the flow of the cooling fluid through the fluid-based cooling device 10b.

As can be seen in figure 6, the first fluid inlet opening region 26b is arranged atop the first heat sink structure portion 20b. The second fluid inlet opening region 27b is arranged atop the second heat sink structure portion 21b. The third fluid inlet opening region 28b is arranged atop the third heat sink structure portion 22b. The fourth fluid inlet opening region 29b is arranged atop the fourth heat sink structure portion 23b. The first and second heat sink structure portions 20b, 23b are arranged atop the two heat-generating elements 110b, 113b. The third and fourth heat sink structure portions 22b, 23b are arranged atop the two non-heat-generating elements 114b, 115b.

The cold cooling fluid flows through the fluid-based cooling device 10b from the direction of the y-axis, i.e. from the left in figure 6, and indicated by a solid arrow P1b. The cold cooling fluid spreads over the second plate 14b as indicated by solid arrows P2b, P3b. Since the width of the first fluid inlet opening region 26b and the second fluid inlet opening region 27b is greater than the width of the third fluid inlet opening region 28b and the fourth fluid inlet opening region 29b, more of the cold cooling fluid passes through the first fluid inlet opening region 26b and the second fluid inlet opening region 27b than through the third fluid inlet opening region 28b and the fourth fluid inlet opening region 29b. Thereby, more cold cooling fluid is dispersed over the first and second heat sink structure portions 20b, 21b than over the third and fourth heat sink structure portions 22b, 23b. Heat is transferred from the heat sink structure portions 20b, 21b, 22b, 23b to the cold cooling fluid. A part of the now hot (i.e. heated) cooling fluid exits the heat sink structure portions 20b, 21b, 22b, 23b into the single intermediate channel 24 as indicated by short dashed arrows P4b. The remaining part of the now hot (i.e. heated) cooling fluid exits the heat sink structure portions 20b, 21b, 22b, 23b into the cavity 54 as indicated by short dashed arrows P5b. The hot cooling fluid exits from the fluid-based cooling device 10b via the first intermediate channel 24 and the cavity 54 in the direction of the y-axis, i.e. to the left (or right) in figure 6, as indicated by long dashed arrows P6b, P7b.

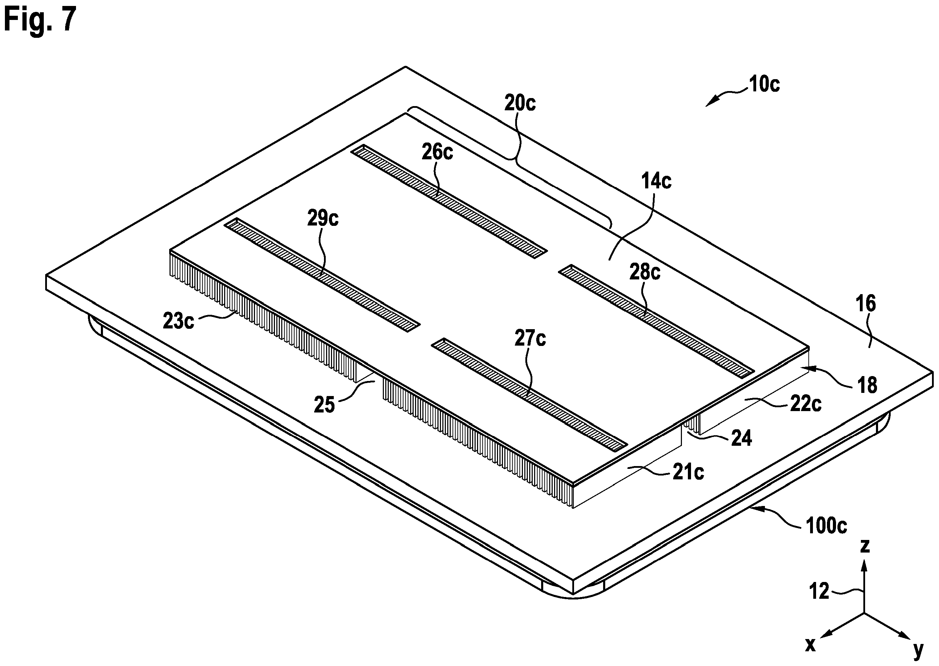

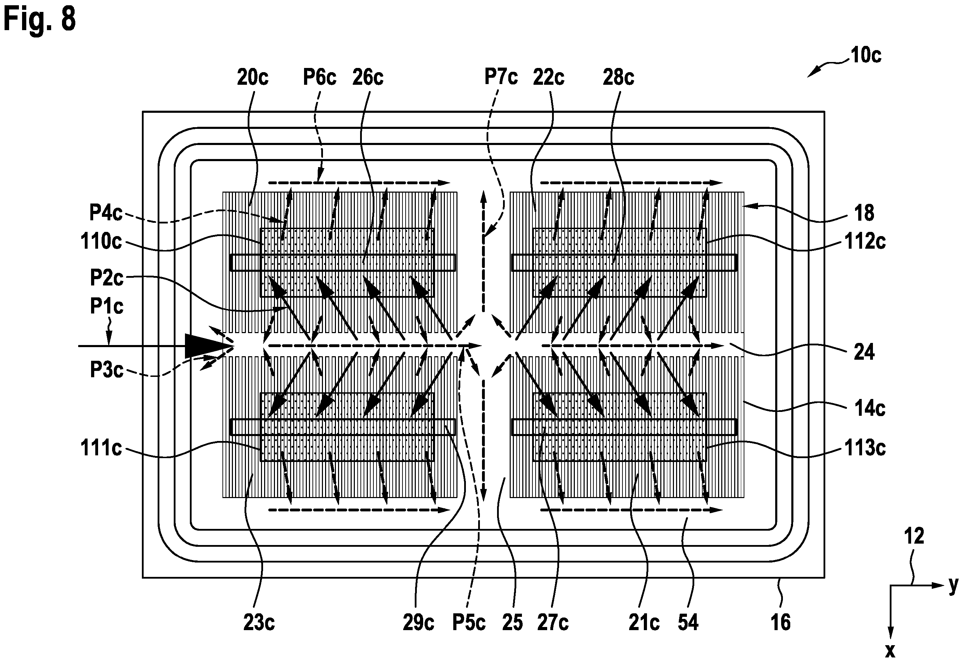

Figures 7 and 8 show a fluid-based cooling device 10c according to a third embodiment with a second plate 14c having four (constant-width) fluid inlet opening regions 26c, 27c, 28c, 29c each having the same width. The fluid-based cooling device 10c is arranged atop a heat source assembly 100c identical to the heat source assembly 100a shown in figure 1.

The fluid-based cooling device 10c according to the third embodiment shown in figures 7 and 8 differs from the fluid-based cooling device 10a according to the first embodiment shown in figures 1 to 3 in having the third (constant-width) fluid inlet opening region 28c and the fourth (constant-width) fluid inlet opening region 29c, in having the third heat sink structure portion 22c and the fourth heat sink structure portion 23c and in having a second intermediate channel 25.

The heat sink structure portions 20c, 21c, 22c, 23c are spatially separated from each other forming the first and second intermediate channels 24, 25 between them. The second intermediate channel 25 is extending in the direction of the x-axis, i.e. perpendicular to the first intermediate channel 24.

Figure 8 shows a top view of the fluid-based cooling device 10c according to the third embodiment. The second plate 14c, the first plate 16, the heat sink structure 18 and the heat spreader 102 are shown transparent in Figure 8 to illustrate the spatial arrangement of the components of the fluid-based cooling device 10c in relation to the components of the heat source assembly 100c. Additionally, arrows P1c to P7c are shown to illustrate the flow of the cooling fluid through the fluid-based cooling device 10c.

As can be seen in figure 8, the first to fourth fluid inlet opening regions 26c, 27c, 28c, 29c are arranged atop the first to fourth heat sink structure portions 20c, 21c, 22c, 23c each. The first to fourth heat sink structure portions 20c, 21c, 22c, 23c are arranged atop the first to fourth heat-generating elements 110c, 111c, 112c, 113c each.

The cold cooling fluid flows through the fluid-based cooling device 10c from the direction of the y-axis, i.e. from the left in figure 8, and indicated by a solid arrow P1c. The cold cooling fluid spreads over the second plate 14c as indicated by solid arrows P2c. After passing through the first to fourth fluid inlet opening regions 26c, 27c, 28c, 29c the cold coolant fluid is dispersed equally among the micro-channels formed by the parallel fins of the first to fourth heat sink structure portions 20c, 21c, 22c, 23c, respectively. Heat is transferred from the heat sink structure portions 20c, 21c, 22c, 23c to the cold cooling fluid. A part of the now hot (i.e. heated) cooling fluid exits the heat sink structure portions 20c, 21c, 22c, 23c into the first intermediate channel 24 as indicated by short dashed arrows P3c. Part of the hot cooling fluid can exit the first intermediate channel 24 into the second intermediate channel 25 as indicated by long dashed arrows P7c. The hot cooling fluid exit the second intermediate channel 25 into the cavity 54. The remaining A part of the now hot (i.e. heated) cooling fluid exits from the heat sink structure portions 20c, 21c, 22c, 23c into the cavity 54 as indicated by short dashed arrows P4c. The hot cooling fluid exits the fluid-based cooling device 10c via the first intermediate channel 24 and the cavity 54 in the direction of the y-axis, i.e. to the left in figure 8, as indicated by long dashed arrows P6c.

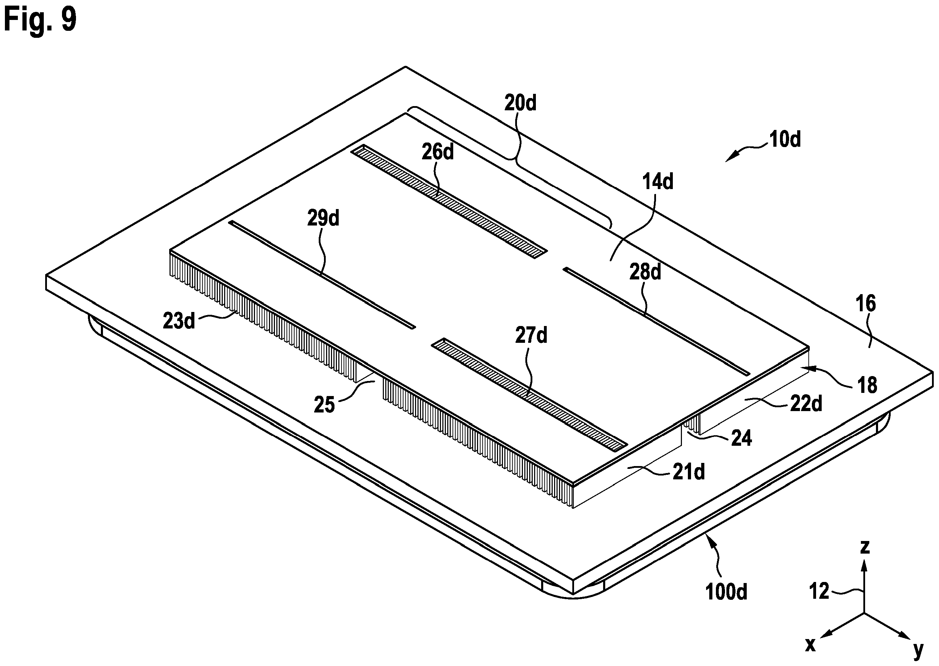

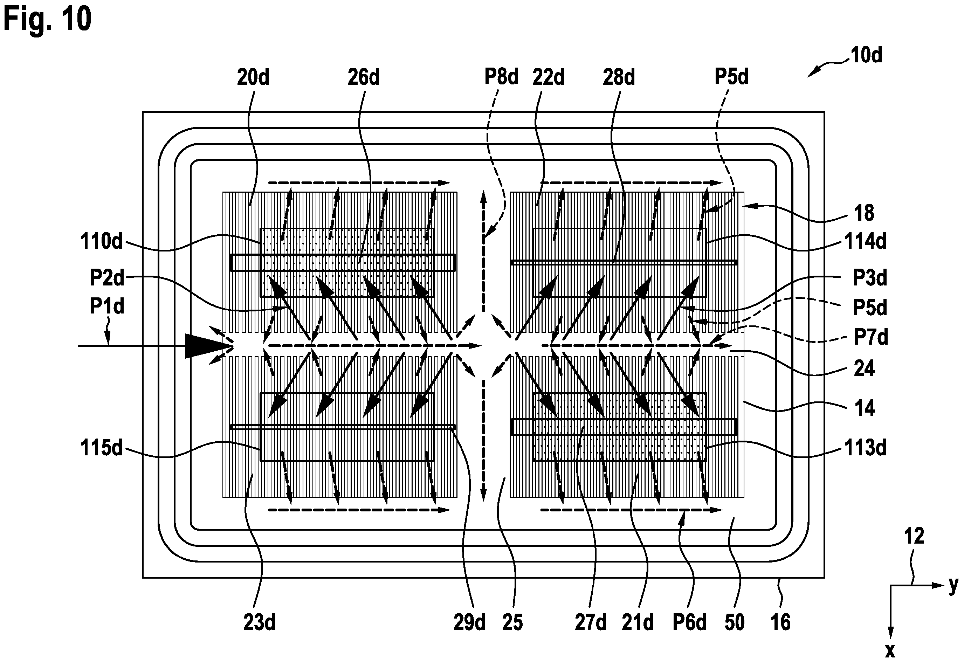

Figures 9 and 10 show a fluid-based cooling device 10d according to a fourth embodiment with a second plate 14d having four distinct (constant-width) fluid inlet opening regions 26d, 27d, 28d, 29d with two of the four fluid inlet opening regions 26d, 27d having a different width than the remaining two fluid inlet opening regions 28d, 29d. The fluid-based cooling device 10d is arranged atop a heat source assembly 100d identical to the heat source assembly 100b shown in figure 4.

The fluid-based cooling device 10d according to the fourth embodiment shown in figure 9 differs from the fluid-based cooling device 10c according to the third embodiment shown in figures 7 and 8 in having a first and a second fluid inlet opening region 26d, 27d having a width greater than a width of a third and a fourth fluid inlet opening region 28d, 29d.

Figure 10 shows a top view of the fluid-based cooling device 10d according to the fourth embodiment. The second plate 14d, the first plate 16, the heat sink structure 18 and the heat spreader 102 are shown transparent in Figure 10 to illustrate the spatial arrangement of the components of the fluid-based cooling device 10d in relation to the components of the heat source assembly 100d. Additionally, arrows P1d to P7d are shown to illustrate the flow of the cooling fluid through the fluid-based cooling device 10d.

As can be seen in figure 10, the first fluid inlet opening region 26d is arranged atop the first heat sink structure portion 20d. The second fluid inlet opening region 27d is arranged atop the second heat sink structure portion 21d. The third fluid inlet opening region 28d is arranged atop the third heat sink structure portion 22d. The fourth fluid inlet opening region 29d is arranged atop the second heat sink structure portion 23d. The first and second heat sink structure portions 26d, 27d are arranged atop the two heat generating elements 110d, 113d. The third and fourth heat sink structure portions 22d, 23d are arranged atop the two non-heat-generating elements 114d, 115d.

The cold cooling fluid flows through the fluid-based cooling device 10d from the direction of the y-axis, i.e. from the left in figure 10, and indicated by a solid arrow P1d. The cold cooling fluid spreads over the second plate 14d as indicated by solid arrows P2d, P3d. Since the width of the first fluid inlet opening region 26d and the second fluid inlet opening region 27d is greater than the width of the third fluid inlet opening region 28d and the fourth fluid inlet opening region 29d, more of the cold cooling fluid passes through the first fluid inlet opening region 26d and the second fluid inlet opening region 27d than through the third fluid inlet opening region 28d and the fourth fluid inlet opening region 29d. Thereby, more cold cooling fluid is dispersed over the first and second heat sink structure portions 20d, 21d than over the third and fourth heat sink structure portions 22d, 23d. Heat is transferred from the heat sink structure portions 20d, 21d, 22d, 23d to the cold cooling fluid. A part of the now hot (i.e. heated) cooling fluid exits the heat sink structure portions 20d, 21d, 22d, 23d into the first intermediate channel 24 as indicated by short dashed arrows P5d. Part of the hot cooling fluid can exit the first intermediate channel 24 into the second intermediate channel 25 as indicated by long dashed arrows P8d. The hot cooling fluid exit the second intermediate channel 25 into the cavity 54. The remaining part of the now hot (i.e. heated) cooling fluid exits the heat sink structure portions 20d, 21d, 22d, 23d into the cavity 54 as indicated by short dashed arrows P5d. The hot cooling fluid exits the fluid-based cooling device 10d via the first intermediate channel 24 and the cavity 54 in the direction of the y-axis, i.e. to the left in figure 6, as indicated by long dashed arrows P6d, P7d.

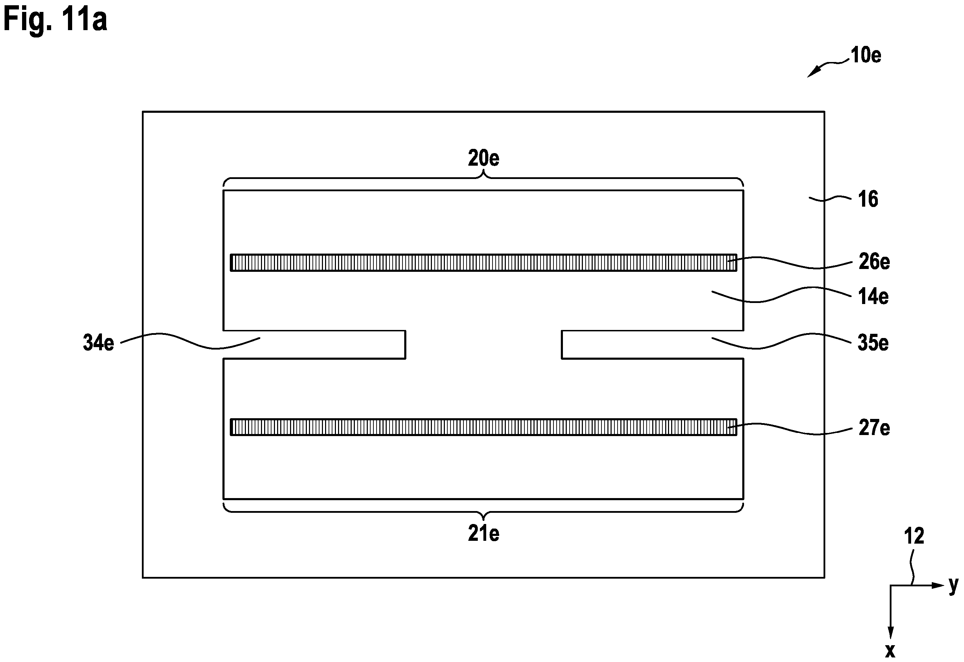

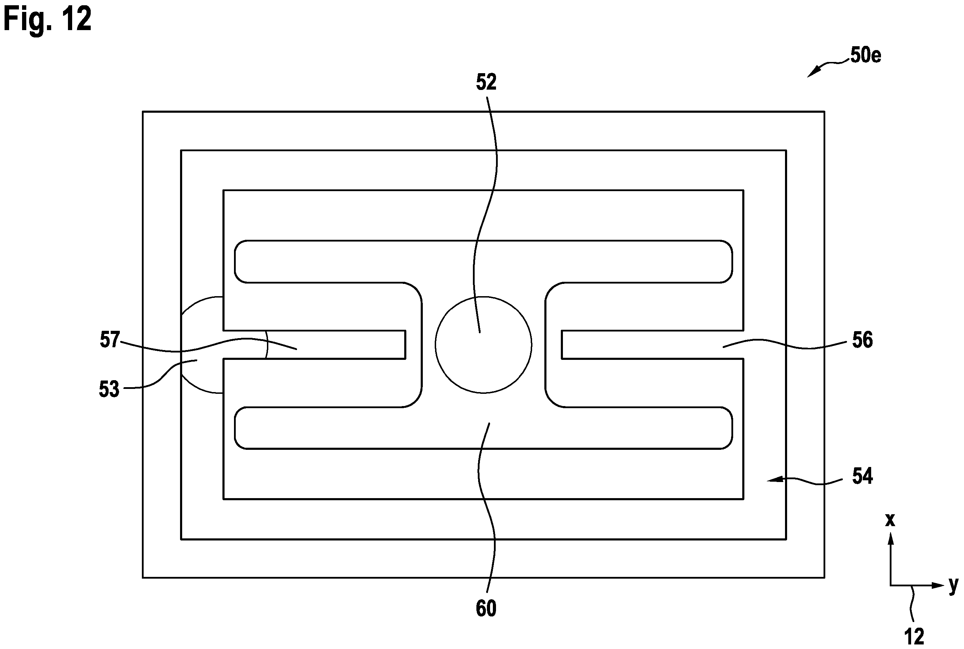

Figure 11a shows a top view of a fluid-based cooling device 10e according to a fifth embodiment with the second plate 14e having two coolant evacuation openings 34e, 35e. The fluid-based cooling device 10e according to the fifth embodiment shown in figure 11a differs from the fluid-based cooling device 10a according to the first embodiment shown in figures 1 to 3 in having the two coolant evacuation openings 34e, 35e through which hot coolant fluid can exit the first and second heat sink structure portions 20e, 21e in the direction of the z-axis into the cavity 54 of the third plate 50e shown in figure 12.

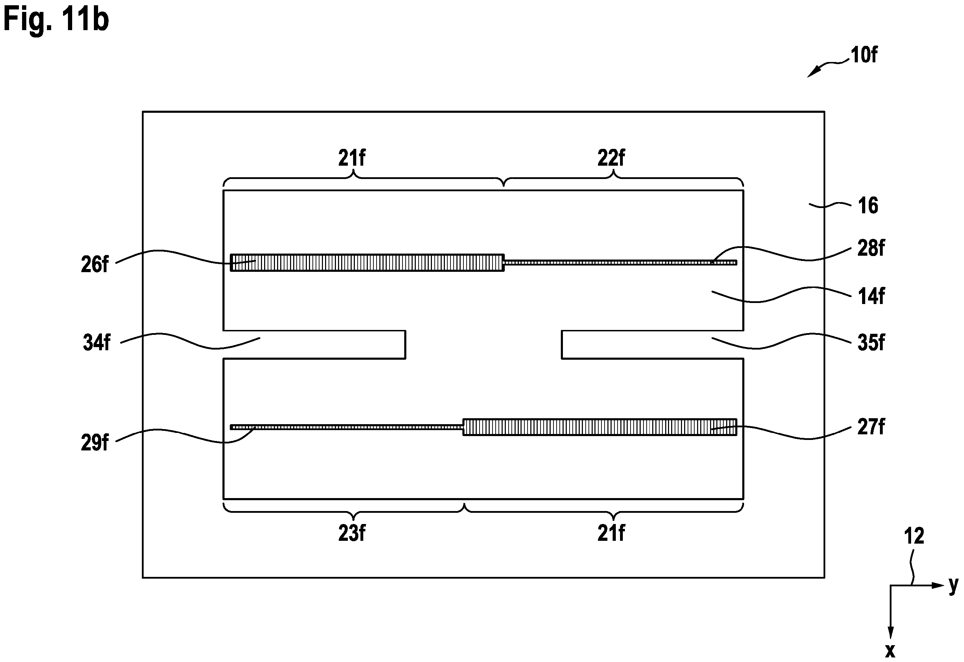

Figure 11b shows a top view of the fluid-based cooling device 10f according to a sixth embodiment with the second plate 14f having two coolant evacuation openings 34f, 35f. The fluid-based cooling device 10f according to the sixth embodiment shown in figure 11b differs from the fluid-based cooling device 10b according to the second embodiment shown in figures 4 to 6 in having the two coolant evacuation openings 34f, 35f through which hot coolant fluid can exit the first to fourth heat sink structure portions 20f, 21f, 22f, 23f in the direction of the z-axis into the cavity 54 of the third plate 50e shown in figure 12.

Figure 12 shows a bottom view of a third plate 50e of the fluid-based cooling device 10e, 10f according to the fifth and sixth embodiment. The third plate 50e comprises a cooling fluid inlet opening region 52, a cooling fluid outlet opening 53, the cavity 54 and a cooling fluid input channel 60.

The cavity 54 comprises a first and a second cooling fluid output channel 56, 57 for transporting the cooling fluid from the first and second coolant evacuation openings 34e, 35e, 34f, 35f of the second plate 14e, 14f shown in figures 11a and 11b to the cooling fluid outlet opening 53. The cooling fluid input channel 60 transports the cooling fluid from the cooling fluid inlet opening region 52 to the fluid inlet opening regions 26e, 27e, 26f, 27f, 28f, 29f of the second plate 14e, 14f shown in figures 11a and 11b.

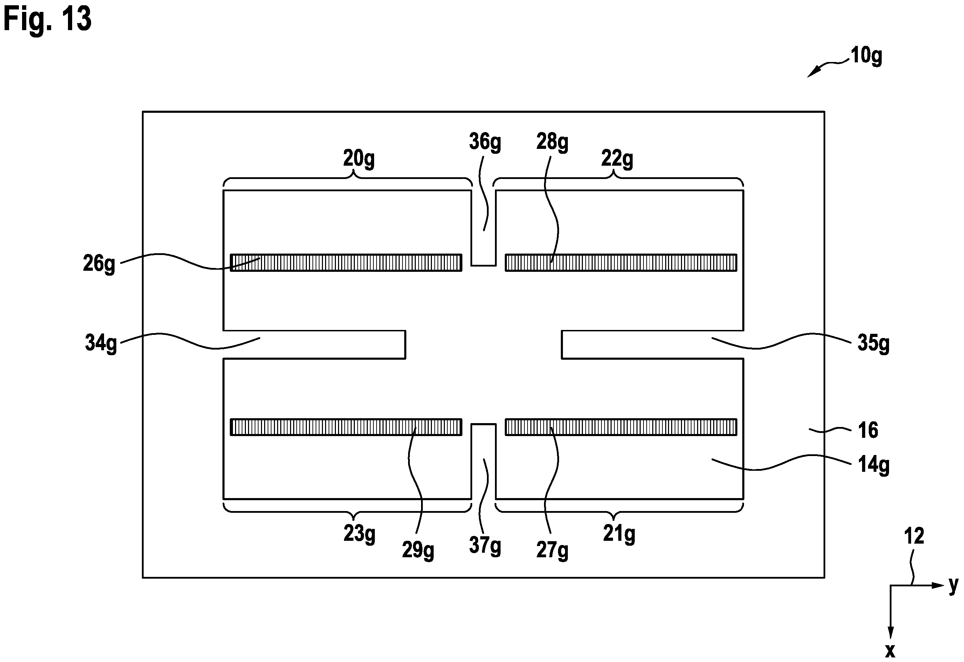

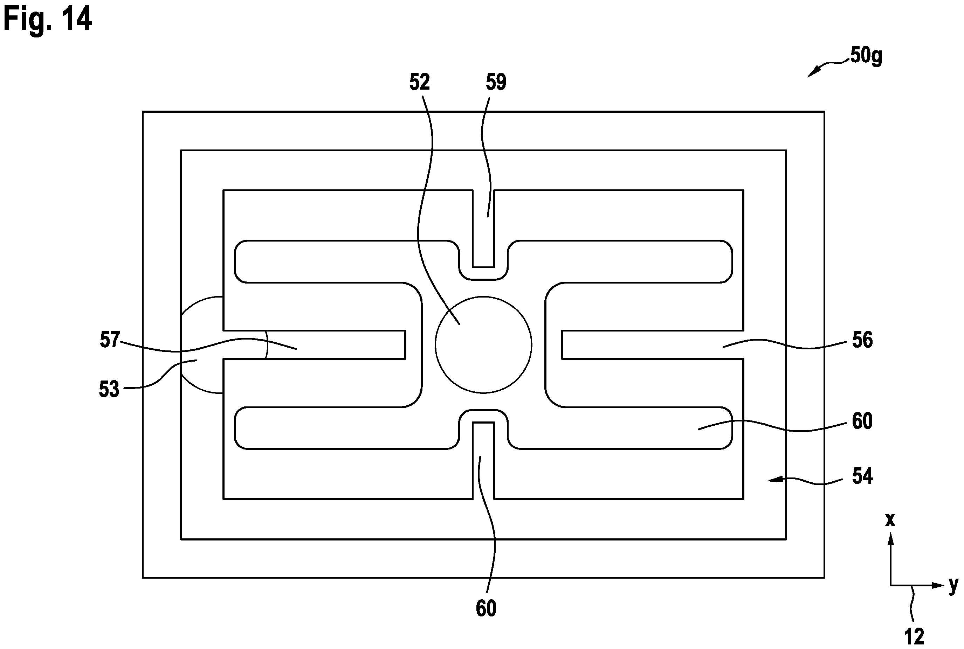

Figure 13 shows a top view of the fluid-based cooling device 10g according to a seventh embodiment with the second plate 14g having four coolant evacuation openings 34g, 35g, 36g, 37g. The fluid-based cooling device 10g according to the seventh embodiment shown in figure 13 differs from the fluid-based cooling device 10c according to the third embodiment shown in figures 7 and 8 in having the four coolant evacuation openings 34g, 35g, 36g, 37g through which hot coolant fluid can exit the first to fourth heat sink structure portions 20g, 21g, 22g, 23g in the direction of the z-axis into the cavity 54 of the third plate 50g shown in figure 14.

Figure 14 shows a bottom view of a third plate 50g of the fluid-based cooling device 10g according to the seventh embodiment. The third plate 50g according to the seventh embodiment shown in figure 14 differs from the third plate 50e according to the fifth and sixth embodiment shown in figure 14a, 14b and 15 in having a third and a fourth cooling fluid output channel 58, 59 for transporting the cooling fluid from the third and fourth coolant evacuation openings 36g, 37g of the second plate 14g shown in figure 13 to the cooling fluid outlet opening 53.

Figure 15 shows a bottom perspective view of the first plate 16 of the fluid-based cooling device 10 according to the first to seventh embodiment. The first plate 16 has four contact surfaces 62, 63, 64, 65 protruding downwards, i.e. in opposite direction of the z-axis, from the first plate 16. The four contact surfaces 62, 63, 64, 65 are spatially separated such that a first and a second intermediate channels 66, 67 for receiving a thermal interface material (TIM) are formed between them. The first and second intermediate channels 66, 67 for receiving the TIM extend in the direction of the y-axis and the x-axis, respectively. During use, the four contact surfaces 62, 63, 64, 65 are in mechanical and thermal contact with the heat spreader 102 of the heat source assembly 100.

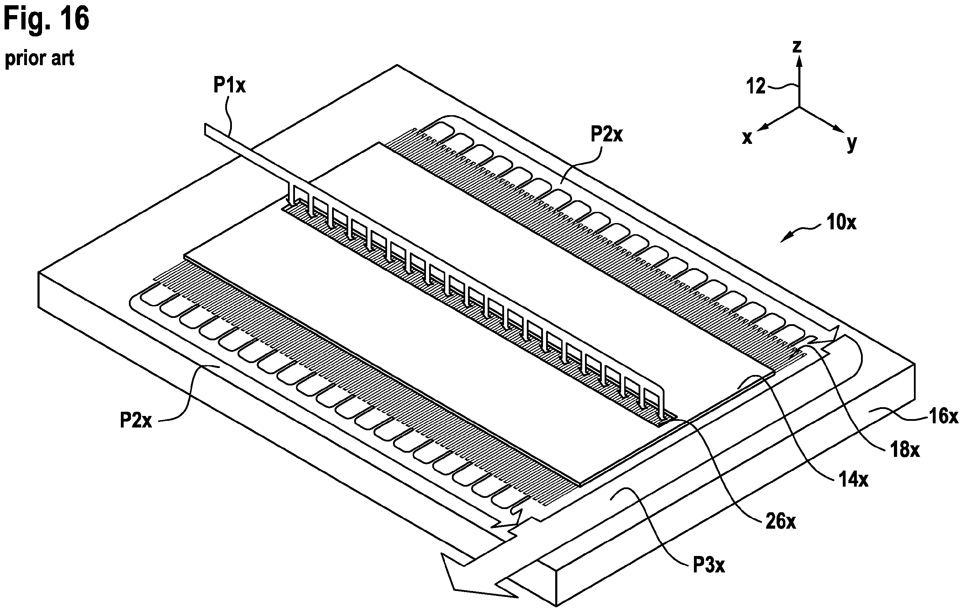

Figure 16 shows a top perspective view of a fluid-based cooling device 10x according to the prior art. The fluid-based cooling device 10x comprises a first plate 16x, a second plate 14x and a heat sink structure 18x arranged between the second plate 14x and the first plate 16x. The heat sink structure 18x comprises an arrangement of parallel fins machined into the first plate 16x extending along the direction of the x-axis. The parallel fins are arranged to form micro-channels between them allowing a cooling fluid to flow between them such that heat can be transferred from the first plate 16x to the cooling fluid.

According to the prior art, the second plate 14x has a fluid inlet opening 26x as an elongated opening extending along the x-axis. The fluid inlet opening 26x is arranged centered atop the heat sink structure 18x to disperse the cooling fluid flowing into the same from the top of the fluid-based cooling device 10x (indicated by an arrow P1x) equally among the micro-channels. Heat is transferred from the heat sink structure 18x to the cooling fluid. The now hot (i.e. heated) cooling fluid exits the heat sink structure portion 18x along and opposite to the direction of the x-axis as indicated by arrows P2x. The hot cooling fluid exits the fluid-based cooling device 10x in the direction of the x-axis, i.e. to the left in figure 16, as indicated by an arrow P3x.

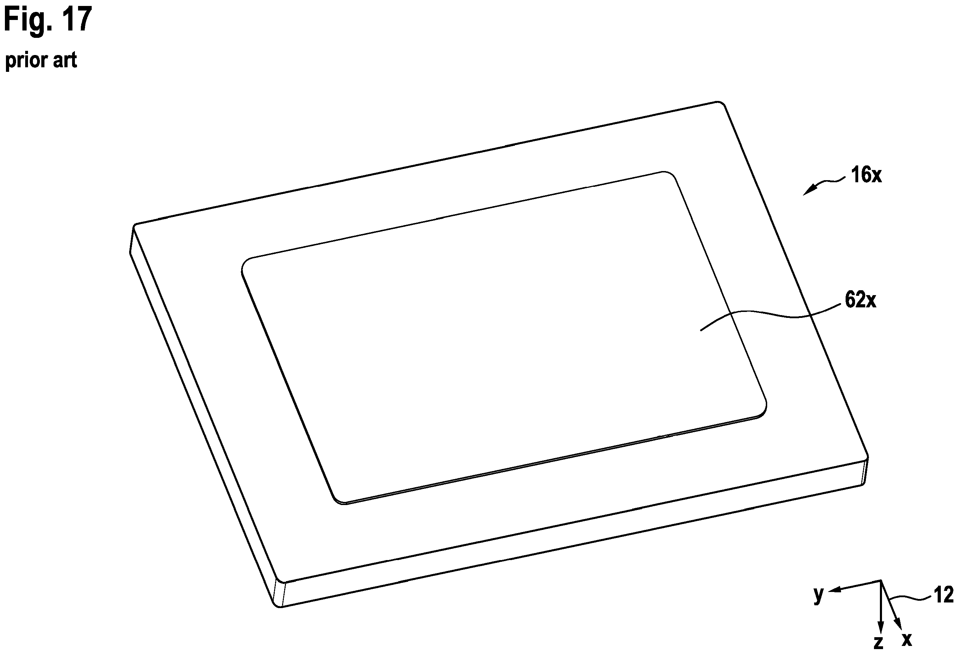

Figure 17 shows a bottom perspective view of the first plate 16x of the fluid-based cooling device 10x according to the prior art. The first plate 16x has a contact surface 62x protruding downwards, i.e. in the opposite direction of the z-axis, from the first plate 16x.

### List of reference signs

- 10: Fluid-based cooling device
- 12: Coordinate system
- 14, 16, 50: Plate
- 18: Heat sink structure
- 20, 21, 22, 23: Heat sink structure portion
- 24, 25, 66, 67: Intermediate channel
- 26, 27, 28, 29: Fluid inlet opening region
- 52: Cooling fluid inlet opening region
- 53: Cooling fluid outlet opening
- 54: Cavity
- 56, 57, 58, 59: Cooling fluid output channel
- 60: Cooling fluid input channel
- 62, 63, 64, 65: Contact surface
- 100: Heat source assembly
- 102: Heat spreader
- 110, 111, 112, 113: Heat-generating elements
- 114, 115: Non-heat generating elements

## Claims

1. Fluid-based cooling device (10) for cooling at least two distinct first heat-generating elements (110, 111) of a heat source assembly (100), the heat source assembly (100) being in thermal contact with the fluid-based cooling device (10), the fluid-based cooling device (10) comprising:
a first plate (16) for thermally contacting the heat source assembly (100);
a heat sink structure (18), wherein the heat sink structure (18) is arranged on or in the first plate (16); and
a second plate (14) for directing a flow of a cooling fluid to the heat sink structure (18), wherein the second plate (14) is arranged on the heat sink structure (18);
**characterized in that** the heat sink structure (18) comprises at least two heat sink structure portions (20, 21) each corresponding to an associated one of the at least two distinct first heat-generating elements (110, 111), and **in that** the second plate (14) comprises at least two fluid inlet opening regions (26, 27), wherein each of the fluid inlet opening regions (26, 27) is associated with a corresponding heat sink structure portion (20, 21) of the at least two heat sink structure portions (20, 21).

2. The fluid-based cooling device according to claim 1, **characterized in that** the heat sink structure (18) comprises a plurality of fins extending in parallel in a first direction, and **in that** the fluid inlet opening regions (26, 27) longitudinally extend in a second direction perpendicular to the first direction.

3. The fluid-based cooling device according to claim 1 or 2, **characterized in that** the fluid inlet opening regions (26, 27) have at least a first width adapted to one or more of the at least two first heat-generating elements (110, 111).

4. The fluid-based cooling device according to claim 3, **characterized in that** the fluid inlet opening regions (28, 29) have a second width provided for one or more of second heat-generating elements or non-heat-generating elements (114, 115) of the heat source assembly (100).

5. The fluid-based cooling device according to claim 4, **characterized in that** the first width is larger than the second width.

6. The fluid-based cooling device according to claim 4 or 5, **characterized in that** a first fluid inlet opening region (26) of the fluid inlet opening regions (26, 27) having the first width and a second fluid inlet opening region (28) of the fluid inlet opening regions (28, 29) having the second width are spatially separated or connected with each other.

7. The fluid-based cooling device according to one of the claims 1 to 6, **characterized in that** the fluid-based cooling device (10) is configured for cooling four distinct first heat-generating elements (110, 111, 112, 113) of the heat source assembly (100), and **in that** the second plate (14) comprises four fluid inlet opening regions (26, 27, 28, 29) corresponding to the four distinct first heat-generating elements (110, 111, 112, 113).

8. The fluid-based cooling device according to one of the claims 1 to 7, **characterized in that** the fluid-based cooling device (10) is configured for cooling a first pair of diagonally arranged first heat-generating elements (110, 113) and a second pair of diagonally arranged second heat-generating elements or non-heat-generating elements (114, 115), **in that** the second plate (14) comprises four fluid inlet opening regions (26, 27, 28, 29), and **in that** two of the four fluid inlet opening regions (26, 27) corresponding to the first heat-generating elements (110, 113) of the first pair have a width which is larger than the width of the other two of the four fluid inlet opening regions (28, 29) corresponding to the second heat-generating elements or non-heat-generating elements (114, 115) of the second pair.

9. The fluid-based cooling device according to one of the claims 1 to 8, **characterized in that** the heat sink structure (18) comprises at least two spatially separated heat sink structure portions (20, 21) forming at least a first intermediate channel (24) and/or a second intermediate channel (25) for diverting the cooling fluid after having been heated therefrom.

10. The fluid-based cooling device according to claim 9, **characterized in that** the heat sink structure (18) comprises a plurality of fins extending in parallel in a first direction, and **in that** the first intermediate channel (24) extends in a second direction perpendicular to the first direction.

11. The fluid-based cooling device according to claim 9, **characterized in that** the heat sink structure (18) comprises a plurality of fins extending in parallel in a first direction, and **in that** the second intermediate (25) channel extends in the first direction.

12. The fluid-based cooling device according to one of the claims 1 to 11, **characterized in that** the fluid-based cooling device (10) comprises a third plate (50) arranged above the first and the second plate (16, 14), and **in that** the first, the second and/or the third plate (16, 14, 50) comprises at least one cooling fluid input or output channel (56, 60).

13. The fluid-based cooling device according to one of the claims 1 to 12, **characterized in that** the first plate (16) comprises at least two contact surfaces (62, 63) protruding from a surface of the first plate (16) facing away from the heat sink structure (18) for thermally contacting a heat spreader (102) of the heat source assembly (100), and **in that** the contact surfaces (62, 63) each correspond to the at least two distinct first heat-generating elements (110, 111).

14. The fluid-based cooling device according to claim 13, **characterized in that** the contact surfaces (62, 63) of the first plate (16) are spatially separated, thereby forming at least one intermediate channel (66) for receiving a thermal interface material (TIM).

15. The fluid-based cooling device according to one of the claims 1 to 14, **characterized in that** the heat sink structure (18) comprises a plurality of fins and/or pins and/or micro-channels defined by the fins.

## Patentansprüche

1. Fluidbasierte Kühlvorrichtung (10) zum Kühlen mindestens zweier verschiedener erster Wärmeerzeugungselemente (110, 111) einer Wärmequellenanordnung (100), wobei die Wärmequellenanordnung (100) in thermischem Kontakt mit der fluidbasierten Kühlvorrichtung (10) ist, wobei die fluidbasierte Kühlvorrichtung (10) umfasst:
eine erste Platte (16) zum thermischen Kontaktieren der Wärmequellenanordnung (100);
eine Kühlkörperstruktur (18), wobei die Kühlkörperstruktur (18) auf oder in der ersten Platte (16) angeordnet ist; und
eine zweite Platte (14) zum Lenken eines Flusses eines Kühlfluids zur Kühlkörperstruktur (18), wobei die zweite Platte (14) auf der Kühlkörperstruktur (18) angeordnet ist;
**dadurch gekennzeichnet, dass** die Kühlkörperstruktur (18) mindestens zwei Kühlkörperstrukturabschnitte (20, 21) umfasst, die jeweils einer zugeordneten der mindestens zwei verschiedenen ersten Wärmeerzeugungselemente (110, 111) entsprechen, und dass die zweite Platte (14) mindestens zwei Fluideinlassöffnungsregionen (26, 27) umfasst, wobei jede der Fluideinlassöffnungsregionen (26, 27) mit einem entsprechenden Kühlkörperstrukturabschnitt (20, 21) der mindesten zwei Kühlkörperstrukturabschnitte (20, 21) zugeordnet ist.

2. Fluidbasierte Kühlvorrichtung nach Anspruch 1, **dadurch gekennzeichnet, dass** die Kühlkörperstruktur (18) eine Vielzahl von Rippen umfasst, die sich parallel in eine erste Richtung erstrecken, und dass sich die Fluideinlassöffnungsregionen (26, 27) längs einer zur ersten Richtung senkrechten zweiten Richtung erstrecken.

3. Fluidbasierte Kühlvorrichtung nach Anspruch 1 oder 2, **dadurch gekennzeichnet, dass** die Fluideinlassöffnungsregionen (26, 27) mindestens eine erste Breite haben, die an ein oder mehr der mindestens zwei ersten Wärmeerzeugungselemente (110, 111) angepasst ist.

4. Fluidbasierte Kühlvorrichtung nach Anspruch 3, **dadurch gekennzeichnet, dass** die Fluideinlassöffnungsregionen (28, 29) eine zweite Breite haben, die für eines oder mehr von zweiten Wärmeerzeugungselementen oder Nicht-Wärmeerzeugungselementen (114, 115) der Wärmequellenanordnung (100) vorgesehen ist.

5. Fluidbasierte Kühlvorrichtung nach Anspruch 4, **dadurch gekennzeichnet, dass** die erste Breite breiter als die zweite Breite ist.

6. Fluidbasierte Kühlvorrichtung nach Anspruch 4 oder 5, **dadurch gekennzeichnet, dass** eine erste Fluideinlassöffnungsregion (26) der Fluideinlassöffnungsregionen (26, 27) mit der ersten Breite und eine zweite Fluideinlassöffnungsregion (28) der Fluideinlassöffnungsregionen (28, 29) mit der zweiten Breite räumlich getrennt oder miteinander verbunden sind.

7. Fluidbasierte Kühlvorrichtung nach einem der Ansprüche 1 bis 6, **dadurch gekennzeichnet, dass** die fluidbasierte Kühlvorrichtung (10) ausgebildet ist, um vier verschiedene erste Wärmeerzeugungselemente (110, 111, 112, 113) der Wärmequellenanordnung (100) zu kühlen, und dass die zweite Platte (14) vier Fluideinlassöffnungsregionen (26, 27, 28, 29) umfasst, die den vier verschiedenen ersten Wärmeerzeugungselementen (110, 111, 112, 113) entsprechen.

8. Fluidbasierte Kühlvorrichtung nach einem der Ansprüche 1 bis 7, **dadurch gekennzeichnet, dass** die fluidbasierte Kühlvorrichtung (10) ausgebildet ist, um ein erstes Paar diagonal angeordneter erster Wärmeerzeugungselemente (110, 113) und ein zweites Paar diagonal angeordneter zweiter Wärmeerzeugungselemente oder Nicht-Wärmeerzeugungselemente (114, 115) zu kühlen, dass die zweite Platte (14) vier Fluideinlassöffnungsregionen (26, 27, 28, 29) umfasst und dass zwei der vier Fluideinlassöffnungsregionen (26, 27), die den ersten Wärmeerzeugungselementen (110, 113) des ersten Paares entsprechen, eine Breite haben, die breiter als die Breite der anderen beiden der vier Fluideinlassöffnungsregionen (28, 29) ist, die den zweiten Wärmeerzeugungselementen oder Nicht-Wärmeerzeugungselementen (114, 115) des zweiten Paares entsprechen,

9. Fluidbasierte Kühlvorrichtung nach einem der Ansprüche 1 bis 8, **dadurch gekennzeichnet, dass** die Kühlkörperstruktur (18) mindestens zwei räumlich getrennte Kühlkörperstrukturabschnitte (20, 21) umfasst, die zumindest einen ersten Zwischenkanal (24) und/oder einen zweiten Zwischenkanal (25) zum Ableiten des Kühlfluids nach ihrer Erwärmung durch dasselbe bilden.

10. Fluidbasierte Kühlvorrichtung nach Anspruch 9, **dadurch gekennzeichnet, dass** die Kühlkörperstruktur (18) eine Vielzahl von Rippen umfasst, die sich parallel in einer ersten Richtung erstrecken, und dass sich der erste Zwischenkanal (24) in einer zur ersten Richtung senkrechten zweiten Richtung erstreckt.

11. Fluidbasierte Kühlvorrichtung nach Anspruch 9, **dadurch gekennzeichnet, dass** die Kühlkörperstruktur (18) eine Vielzahl von Rippen umfasst, die sich parallel in einer ersten Richtung erstrecken, und dass sich der zweite Zwischenkanal (25) in der ersten Richtung erstreckt.

12. Fluidbasierte Kühlvorrichtung nach einem der Ansprüche 1 bis 11, **dadurch gekennzeichnet, dass** die fluidbasierte Kühlvorrichtung (10) eine dritte Platte (50) umfasst, die über der ersten und der zweiten Platte (16, 14) angeordnet ist, und dass die erste, die zweite und/oder die dritte Platte (16, 14, 50) mindestens einen Kühlfluideinlass- oder -auslasskanal (56, 60) umfasst.

13. Fluidbasierte Kühlvorrichtung nach einem der Ansprüche 1 bis 12, **dadurch gekennzeichnet, dass** die erste Platte (16) mindestens zwei Kontaktflächen (62, 63) umfasst, die von einer Oberfläche der ersten Platte (16) von der Kühlkörperstruktur (18) abgewandt vorstehen, um einen Wärmeverteiler (102) der Wärmequellenanordnung (100) thermisch zu kontaktieren, und dass die Kontaktflächen (62, 63) jeweils den mindestens zwei verschiedenen ersten Wärmeerzeugungselementen (110, 111) entsprechen.

14. Fluidbasierte Kühlvorrichtung nach Anspruch 13, **dadurch gekennzeichnet, dass** die Kontaktflächen (62, 63) der ersten Platte (16) räumlich getrennt sind und dadurch mindestens einen Zwischenkanal (66) zur Aufnahme eines thermischen Interface-Materials (TIM) bilden.

15. Fluidbasierte Kühlvorrichtung nach einem der Ansprüche 1 bis 14, **dadurch gekennzeichnet, dass** die Kühlkörperstruktur (18) eine Vielzahl von Rippen und/oder Stiften und/oder von den Rippen definierten Mikrokanälen umfasst.

## Revendications

1. Dispositif de refroidissement à base de fluide (10) pour refroidir au moins deux premiers éléments générateurs de chaleur distincts (110, 111) d'un ensemble source de chaleur (100), l'ensemble source de chaleur (100) étant en contact thermique avec le dispositif de refroidissement à base de fluide (10), le dispositif de refroidissement à base de fluide (10) comprenant :
une première plaque (16) destinée à venir en contact thermique avec l'ensemble source de chaleur (100) ;
une structure de dissipateur thermique (18), dans lequel la structure de dissipateur thermique (18) est agencée sur ou dans la première plaque (16) ; et
une deuxième plaque (14) pour diriger un écoulement d'un fluide de refroidissement vers la structure de dissipateur thermique (18), dans lequel la deuxième plaque (14) est agencée sur la structure de dissipateur thermique (18) ;
**caractérisé en ce que** la structure de dissipateur thermique (18) comprend au moins deux parties de structure de dissipateur thermique (20, 21) correspondant chacune à l'un associé des au moins deux premiers éléments générateurs de chaleur distincts (110, 111), et **en ce que** la deuxième plaque (14) comprend au moins deux zones d'ouverture d'entrée de fluide (26, 27), dans lequel chacune des zones d'ouverture d'entrée de fluide (26, 27) est associée à une partie de structure de dissipateur thermique correspondante (20, 21) des au moins deux parties de structure de dissipateur thermique (20, 21).

2. Dispositif de refroidissement à base de fluide selon la revendication 1, **caractérisé en ce que** la structure de dissipateur thermique (18) comprend une pluralité d'ailettes s'étendant en parallèle dans une première direction, et **en ce que** les zones d'ouverture d'entrée de fluide (26, 27) s'étendent longitudinalement dans une seconde direction perpendiculaire à la première direction.

3. Dispositif de refroidissement à base de fluide selon la revendication 1 ou 2, **caractérisé en ce que** les zones d'ouverture d'entrée de fluide (26, 27) ont au moins une première largeur adaptée à un ou plusieurs des au moins deux premiers éléments générateurs de chaleur (110, 111).

4. Dispositif de refroidissement à base de fluide selon la revendication 3, **caractérisé en ce que** les zones d'ouverture d'entrée de fluide (28, 29) ont une seconde largeur prévue pour un ou plusieurs des seconds éléments générateurs de chaleur ou des éléments non générateurs de chaleur (114, 115) de l'ensemble source de chaleur (100).

5. Dispositif de refroidissement à base de fluide selon la revendication 4, **caractérisé en ce que** la première largeur est plus grande que la seconde largeur.

6. Dispositif de refroidissement à base de fluide selon la revendication 4 ou 5, **caractérisé en ce qu'**une première zone d'ouverture d'entrée de fluide (26) des zones d'ouverture d'entrée de fluide (26, 27) ayant la première largeur et une seconde zone d'ouverture d'entrée de fluide (28) des zones d'ouverture d'entrée de fluide (28, 29) ayant la seconde largeur sont séparées spatialement ou connectées l'une à l'autre.

7. Dispositif de refroidissement à base de fluide selon l'une des revendications 1 à 6, **caractérisé en ce que** le dispositif de refroidissement à base de fluide (10) est configuré pour refroidir quatre premiers éléments générateurs de chaleur distincts (110, 111, 112, 113) de l'ensemble source de chaleur (100), et **en ce que** la deuxième plaque (14) comprend quatre zones d'ouverture d'entrée de fluide (26, 27, 28, 29) correspondant aux quatre premiers éléments générateurs de chaleur distincts (110, 111, 112, 113).

8. Dispositif de refroidissement à base de fluide selon l'une des revendications 1 à 7, **caractérisé en ce que** le dispositif de refroidissement à base de fluide (10) est configuré pour refroidir une première paire de premiers éléments générateurs de chaleur agencés en diagonale (110, 113) et une seconde paire de seconds éléments générateurs de chaleur ou d'éléments non générateurs de chaleur agencés en diagonale (114, 115), **en ce que** la deuxième plaque (14) comprend quatre zones d'ouverture d'entrée de fluide (26, 27, 28, 29), et **en ce que** deux des quatre zones d'ouverture d'entrée de fluide (26, 27) correspondant aux premiers éléments générateurs de chaleur (110, 113) de la première paire ont une largeur qui est plus grande que la largeur des deux autres des quatre des zones d'ouverture d'entrée de fluide (28, 29) correspondant aux seconds éléments générateurs de chaleur ou aux éléments non générateurs de chaleur (114, 115) de la seconde paire.

9. Dispositif de refroidissement à base de fluide selon l'une des revendications 1 à 8, **caractérisé en ce que** la structure de dissipateur thermique (18) comprend au moins deux parties de structure de dissipateur thermique séparées spatialement (20, 21) formant au moins un premier canal intermédiaire (24) et/ou un second canal intermédiaire (25) pour détourner le fluide de refroidissement après avoir été chauffé par celle-ci.

10. Dispositif de refroidissement à base de fluide selon la revendication 9, **caractérisé en ce que** la structure de dissipateur thermique (18) comprend une pluralité d'ailettes s'étendant parallèlement dans une première direction, et **en ce que** le premier canal intermédiaire (24) s'étend dans une seconde direction perpendiculaire à la première direction.

11. Dispositif de refroidissement à base de fluide selon la revendication 9, **caractérisé en ce que** la structure de dissipateur thermique (18) comprend une pluralité d'ailettes s'étendant en parallèle dans une première direction, et **en ce que** le second canal intermédiaire (25) s'étend dans la première direction.

12. Dispositif de refroidissement à base de fluide selon l'une des revendications 1 à 11, **caractérisé en ce que** le dispositif de refroidissement à base de fluide (10) comprend une troisième plaque (50) agencée au-dessus des première et deuxième plaques (16, 14), et **en ce que** la première, la deuxième et/ou la troisième plaque (16, 14, 50) comprend au moins un canal d'entrée ou de sortie de fluide de refroidissement (56, 60).

13. Dispositif de refroidissement à base de fluide selon l'une des revendications 1 à 12, **caractérisé en ce que** la première plaque (16) comprend au moins deux surfaces de contact (62, 63) faisant saillie à partir d'une surface de la première plaque (16) orientée à l'opposé de la structure de dissipateur thermique (18) pour venir en contact thermique avec un dissipateur de chaleur (102) de l'ensemble source de chaleur (100), et **en ce que** les surfaces de contact (62, 63) correspondent chacune aux au moins deux premiers éléments générateurs de chaleur distincts (110, 111) .

14. Dispositif de refroidissement à base de fluide selon la revendication 13, **caractérisé en ce que** les surfaces de contact (62, 63) de la première plaque (16) sont séparées spatialement, en formant ainsi au moins un canal intermédiaire (66) pour recevoir un matériau d'interface thermique (TIM).

15. Dispositif de refroidissement à base de fluide selon l'une des revendications 1 à 14, **caractérisé en ce que** la structure de dissipateur thermique (18) comprend une pluralité d'ailettes et/ou de broches et/ou de micro-canaux définis par les ailettes.
